# DEMANDE DE BREVET EUROPEEN

(11) **EP 4 390 562 A1**
(43) Date de publication de la demande: **26.06.2024**
(21) Numéro de dépôt: 23220046.9
(22) Date de dépôt: 22.12.2023
(51) Int. Cl.: G04B 19/30, G04G 17/02, G04C 10/02, G04G 17/04, G04G 19/00, G04G 21/04, G04R 60/06

(54) **MONTRE COMPRENANT UN DISPOSITIF DE COMMUNICATION SANS FIL**

(30) Priorité: 22.12.2022 EP 22215943
(71) Demandeur: ETA SA Manufacture Horlogère Suisse, 2540 Grenchen (CH)
(72) Inventeur: DUBUGNON, Dominique, 1162 Saint-Prex (CH); TORTORA, Pierpasquale, 2000 Neuchâtel (CH); HUOT-MARCHAND, Sylvain, 2743 Eschert (CH); COURVOISIER, Raphaël, 2035 Corcelles (CH)
(74) Mandataire: ICB SA

(57) **Abrégé**

Un aspect de l'invention concerne un cadran (2a, 2b) de montre (1) comprenant un dispositif de communication sans fil autonome (3), un tel cadran (2a, 2b) comprend des faces visible et cachée (20a, 20b), ledit cadran (2a, 2b) étant formé par un empilement (9a, 9b) de couches minces (10, 11, 12, 13, 14) de matière s'étendant entre ces deux faces (20a, 20b), chacune desdites couches (10, 11, 12, 13, 14) comprenant un ou plusieurs des éléments fonctionnels compris dans ledit dispositif (3) :
- un module émetteur-récepteur (23) d'ondes radioélectriques ;
- au moins une source lumineuse (4) ;
- une unité d'alimentation électrique autonome (21), et
- une unité de contrôle (7) pour gérer le fonctionnement de la dite au moins une source lumineuse (4) et du module émetteur-récepteur (23).

## Description

### Domaine technique de l'invention

La présente invention concerne une montre dont le cadran est doté d'un dispositif de communication sans fil, ledit dispositif étant totalement autonome.

### Arrière-plan technologique

Dans l'art antérieur, on connaît des montres électromécaniques à aiguilles dans lesquelles l'aiguille des heures et l'aiguille des minutes d'affichage de l'heure courante sont entraînées par des rouages d'un mécanisme d'un mouvement horloger. Dans ce contexte, il peut arriver qu'en raison des chocs subis par la montre, de la présence de champs électromagnétiques ou d'autres perturbations externes le fonctionnement de mécanisme s'en trouve perturbé. Afin de limiter voire d'éviter tout endommagement de ce mécanisme, il est souvent nécessaire d'identifier très tôt la ou les perturbations qui peuvent en être la cause ainsi que les dysfonctionnements engendrés dans ce mécanisme par ces perturbations.

Dans ce contexte, on comprend qu'il existe un besoin de trouver une solution, qui ne présente pas les inconvénients de l'art antérieur.

### Résumé de l'invention

L'invention a pour but de pallier ces inconvénients en proposant une montre pourvue d'un cadran comportant un dispositif de communication sans fil qui soit autonome et qui participe à avertir le porteur de la montre au sujet dysfonctionnements détectées dans cette dernière.

Un aspect de l'invention concerne un cadran de montre comprenant un dispositif de communication sans fil autonome, un tel cadran comprend des faces visible et cachée, ledit cadran étant formé par un empilement de couches minces de matière s'étendant entre ces deux faces, chacune desdites couches comprenant un ou plusieurs des éléments fonctionnels compris dans ledit dispositif :
- un module émetteur-récepteur d'ondes radioélectriques ;
- au moins une source lumineuse ;
- une unité d'alimentation électrique autonome, et
- une unité de contrôle pour gérer le fonctionnement de la dite au moins une source lumineuse et du module émetteur-récepteur.

Dans d'autres modes de réalisation :
- le module émetteur-récepteur fonctionne selon une technologie Bluetooth, Wifi et/ou NFC ;
- l'empilement de couches minces de matière comprend une première couche pourvue de la face visible du cadran et comprenant ledit au moins un module émetteur-récepteur et ladite au moins une source lumineuse ;
- ledit au moins un module émetteur-récepteur est agencé dans une cavité ménagée dans la face cachée de ce cadran ;
- ladite première couche est configurée pour être traversé en tout ou partie par un rayonnement lumineux notamment par un rayonnement solaire ;
- ladite première couche est en tout ou partie transparente ou translucide ;
- l'empilement de couches minces de matière comporte une deuxième couche comprenant un module photovoltaïque constituant l'unité d'alimentation électrique autonome ;
- la deuxième couche comprend un substrat sur lequel le module photovoltaïque est imprimé ;
- ledit module photovoltaïque est disposé sur une zone active de ladite deuxième couche, ladite zone étant configurée pour recevoir des rayonnements lumineux provenant de la première couche de l'empilement de couches minces de matière ;
- l'empilement comporte une troisième couche comprenant un accumulateur d'énergie électrique constituant l'unité d'alimentation électrique autonome ;
- la troisième couche comprend un substrat sur lequel l'accumulateur d'énergie électrique est imprimé ;
- l'empilement comporte une quatrième couche formant une face cachée du cadran comprenant l'unité de contrôle ;
- l'empilement comporte une troisième couche comprenant une face cachée du cadran comportant l'unité de contrôle et un accumulateur d'énergie électrique constituant l'unité d'alimentation électrique autonome ;
- la première couche est rigide relativement aux autres couches comprises dans l'empilement de couches minces de matière qui sont souples ;
- lesdites faces visible et cachée sont planes ou bombées.

Un autre aspect de l'invention concerne une montre comprenant un tel cadran.

Avantageusement, la montre comprend un mouvement horloger mécanique, électronique ou électromécanique.

### Brève description des figures

Les buts, avantages et caractéristiques de l'invention apparaîtront mieux dans la description suivante sur la base d'au moins une forme d'exécution non limitative illustrée par les dessins sur lesquels :
la figure 1 représente une vue en perspective d'une montre comprenant un cadran pourvu d'un dispositif de communication sans fil qui est autonome, selon des modes de réalisation de l'invention ;
la figure 2 représente une vue éclatée d'une première variante du cadran formé d'un empilement de quatre couches superposées, lesdites couches comportant chacune un ou plusieurs éléments constitutifs du dispositif de communication sans fil, selon un premier mode de réalisation de l'invention ;
la figure 3 représente une vue schématique de cette première variante du cadran pourvue du dispositif de communication sans fil, selon le premier mode de réalisation de l'invention ;
la figure 4 représente une vue éclatée d'une deuxième variante du cadran formé d'un empilement de trois couches superposées, lesdites couches comportant chacune un ou plusieurs éléments constitutifs du dispositif de communication sans fil, selon un deuxième mode de réalisation de l'invention, et
la figure 5 représente une vue schématique de cette deuxième variante du cadran pourvue du dispositif de communication sans fil, selon le deuxième mode de réalisation de l'invention.

### Description détaillée de l'invention

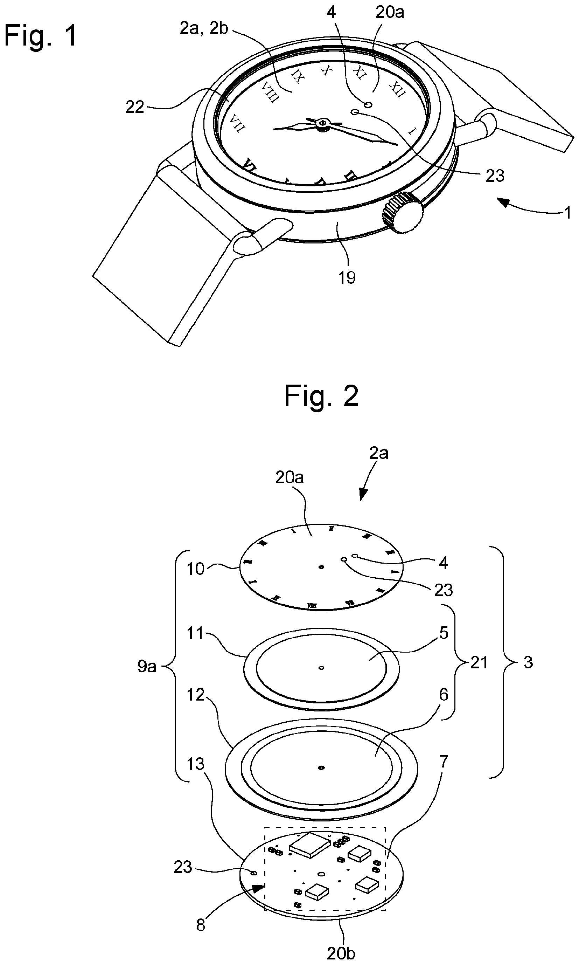

La figure 1 illustre une représentation schématique d'une montre 1 comprenant un boitier 19 pourvu d'une carrure à laquelle sont fixés un fond et une glace 22, d'un ensemble de composants formant un mouvement horloger, et d'un cadran 2a, 2b disposé entre le mouvement horloger et la glace 22.

Le mouvement horloger entraîne de façon connue de l'homme du métier un aiguillage comprenant une aiguille des heures, une aiguille des minutes et éventuellement une aiguille des secondes. À cet effet, le cadran 2a, 2b comporte un trou traversant recevant l'axe des aiguilles. Ce cadran 2a, 2b comprend aussi deux faces 20a, 20b dont :
- une face dite visible 20a de l'extérieur de la montre 1 aussi appelée « *partie visible* » ou « *partie supérieure visible* » de ce cadran 2a, 2b, et
- une face dite cachée 20b agencée en regard du mouvement horloger dans une enceinte du boitier 19 de la montre 1, cette face 20b étant autrement appelée « *partie* cachée » ou « *partie inférieure* cachée » de ce cadran 2a, 2b.

Une telle face visible 20a peut comprendre de manière non limitative et non exhaustive au moins une représentation graphique telle que :
- un élément de repère (ou d'affichage) comme par exemple un chiffre, un index, un trait ou encore un point contribuant à participer avec/sans les aiguilles à l'affichage d'une information/grandeur horlogère ou d'une information/grandeur physique mesurée par un capteur ou similaire compris dans le mouvement ;
- une inscription, un motif, un texte, un logo, etc.

Ces faces visible 20a et cachée 20b sont sensiblement planes et/ou parallèles et/ou opposées l'une à l'autre. On notera dans d'autres variantes que le cadran 2a, 2b peut comprendre une face visible 20a bombée et une face cachée 20b qui peut être bombée ou plane. Ces faces 20a, 20b sont aussi reliées entre elles par une paroi périphérique de ce cadran 2a, 2b.

On notera par ailleurs que dans les modes de réalisation illustrés sur les figures 1 à 5, le cadran 2a, 2b a de préférence une forme circulaire. On comprend que l'invention peut également être mise en oeuvre pour des cadrans 2a, 2b ayant d'autres formes comme par exemple une forme triangulaire ou encore une forme similaire à celle d'un quadrilatère.

Dans les modes de réalisation de l'invention, le mouvement horloger est un mouvement mécanique. Dans une alternative ce mouvement peut être un mouvement électromécanique ou électronique. On parlera d'ailleurs par la suite d'une montre mécanique lorsque son mouvement est mécanique, d'une montre électronique lorsqu'elle comporte un mouvement électronique et d'une montre électromécanique lorsqu'elle comporte un mouvement électromécanique.

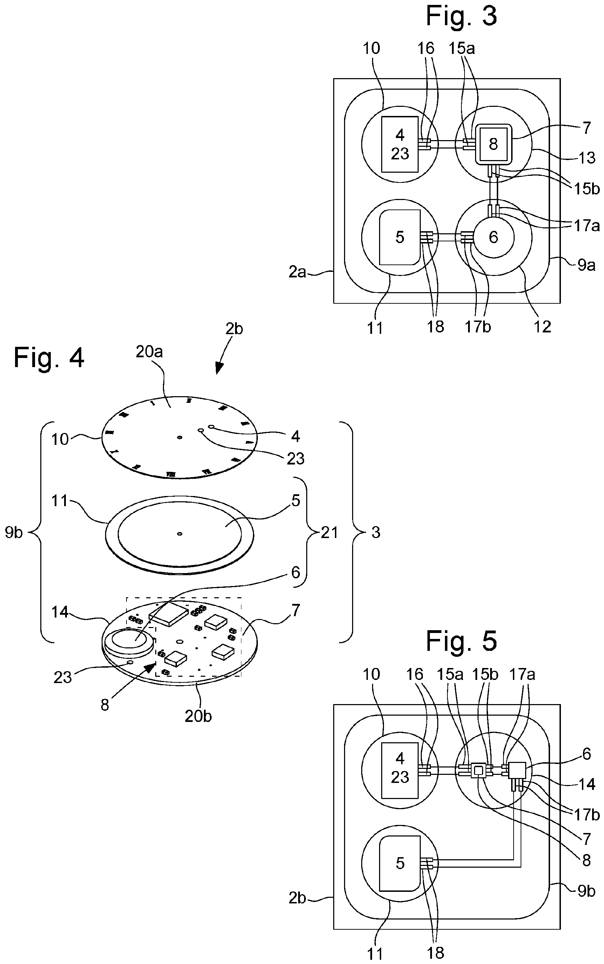

En référence aux figures 2 et 4, un tel cadran 2a, 2b comprend un dispositif de communication sans fil autonome 3. Ce dispositif de communication 3 comprend ses propres moyens d'alimentation électrique comme nous le verrons par la suite. Un tel dispositif de communication sans fil 3 est dit autonome notamment par rapport au mouvement de la montre 1 et en particulier de la source d'énergie de ce mouvement, par exemple lorsque cette source est une alimentation électrique comme dans un mouvement électromécanique. Dans ces conditions, on comprend que l'énergie utilisée par ce dispositif de communication sans fil 3 ne se fait pas au détriment de l'autonomie du mouvement.

Dans ce contexte, le cadran 2a, 2b peut être monté de manière amovible dans la montre 1 quel que soit le type de la montre 1. La seule condition à respecter est que le cadran 2a, 2b comprenne ce dispositif de communication 3 qui est donc autonome par rapport au mouvement de la montre 1. On notera que ce cadran 2a, 2b est aussi appelé « *cadran autonome* » car il n'est pas connecté notamment électriquement au mouvement de la montre 1. Ce cadran 2a, 2b peut être considéré comme une pièce rapportée à la montre 1.

Un tel dispositif de communication 3 permet à cette montre 1 d'échanger des données avec un appareil électronique. Ces données peuvent comprendre des informations relatives à des fonctions mises en oeuvre par la montre 1 comme des fonctions horlogères ou encore des fonctions mettant en oeuvre une surveillance d'évènements relatifs au fonctionnement du mouvement de cette montre 1 tels qu'un événement relatif à un défaut d'étanchéité du boitier 19 de cette montre 1. D'autres exemples de types d'informations susceptibles d'être comprises dans ces données, peuvent être de manière non limitative et non exhaustive :
- le comptage du nombre de passage d'au moins une aiguille, si la montre 1 en est pourvue, permettant par exemple de déterminer le temps de fonctionnement réel de cette montre 1, par exemple entre deux services de révision ou d'entretien de cette montre ;
- le nombre et la nature (faible, fort) de chocs reçus par le boitier 19, lorsque le cadran 2a, 2b est pourvu d'un accéléromètre ;
- le nombre et l'intensité des expositions de la montre 1 à des champs magnétiques, lorsque le cadran 2a, 2b est pourvu d'un capteur magnétique ;
- la pression et/ou l'humidité interne du boitier 19, pouvant indiquer une perte d'étanchéité de la montre 1, lorsque le cadran est pourvu d'un capteur de pression et/ou d'humidité ;
- l'orientation de la montre 1, et la durée de ces orientations, lorsque le cadran 2a, 2b est équipé d'un gyroscope, afin par exemple d'améliorer le réglage de la montre en fonction de son porteur, ou d'adapter la fréquence des services d'entretien nécessaires au bon fonctionnement de la montre 1, cela peut s'inscrire dans le cadre d'une maintenance prédictive ;
- la détection de bruit de fonctionnement anormaux lorsque le cadran 2a, 2b est équipé d'un capteur acoustique, permettant de prédire ou de signaler une panne/un dysfonctionnement.

On comprend donc que dans ce contexte, le dispositif de communication 3 peut comprendre de manière non limitative et non exhaustive, les capteurs d'évènement suivants :
- capteur de positionnement d'une aiguille ;
- capteur accéléromètre ;
- capteur de pression ;
- capteur d'humidité ;
- capteur de position angulaire ;
- capteur gyroscopique et/ou inertiel sous la forme d'un composant électronique de type circuit microsystèmes électromécaniques gyroscopique et/ou inertiel ;
- capteur acoustique.

On notera, que l'appareil électronique évoqué précédemment est de préférence un appareil portable c'est-à-dire qui est susceptible d'être porté et transporté par un utilisateur, et aussi d'être fonctionnel lors de son transport. Il peut s'agir par exemple d'un ordiphone ou encore d'une phablette. De manière alternative, cet appareil électronique peut être une ordinateur notamment un ordinateur portatif. Dans ce contexte, cet appareil comprend une unité de communication compatible avec un module émetteur-récepteur 23 du dispositif de communication 3 du cadran 2a, 2b de la montre 1.

Ce dispositif de communication 3 compris dans ce cadran 2a, 2b, comporte au moins une source lumineuse 4 aussi appelée source de lumière, une unité d'alimentation électrique autonome 21, le module émetteur-récepteur 23, et une unité de contrôle 7.

Dans ce dispositif 3, ladite au moins une source lumineuse 4 est mise en oeuvre notamment pour participer à l'affichage des différents paramètres de fonctionnement du dispositif de communication 3 comme par exemple :
- l'établissement d'une connexion avec ledit appareil électronique ;
- le type de connexion : Bluetooth, WiFi, etc ;
- le trafic réseau présent sur la connexion établie entre la montre et l'appareil ;
- la bande passante sur la connexion établie entre la montre et l'appareil ;
- le début ou la fin de la transmission/téléchargement de données entre la montre et l'appareil ;
- etc.

Dans ce dispositif de communication 3, chaque source lumineuse 4 peut correspondre à n'importe quel élément électroluminescent sélectionné dans une liste comprenant de manière non exhaustive et non limitative :
- un condensateur électroluminescent plus connu sous l'acronyme LEC pour « Light-Emitting Capacitor » ;
- une diode électroluminescente de type LED (acronyme de « Light-Emitting Diode »), OLED (acronyme de « Organic Light-Emitting Diode »), AMOLED (acronyme de « Active-Matrix Organic Light-Emitting Diode ») ou encore QLED (acronyme de « Quantum Light-emitting diode » ;
- tout matériau électroluminescent activé par un champ électrique local ;
- tout matériau électroluminescent activé par un courant électrique ;
- toutes combinaisons de ces éléments électroluminescents.

On notera que cette source lumineuse 4 peut dans certains modes de réalisation de l'invention, être une source lumineuse 4 apte à former une source lumineuse étendue. Ceci permet de donner une forme prédéterminée à la source lumineuse étendue, typiquement, sans que cela ne soit exhaustif ni limitatif, une forme relative à une représentation graphique relative à un paramètre de fonctionnement du dispositif de communication 3 telle qu'un chiffre, une lettre, un logo ou encore un texte. On notera en complément, que cette source lumineuse 4 peut produire de la lumière dans n'importe quelle couleur et/ou dans n'importe quelle direction.

Dans ce dispositif de communication 3, ledit module émetteur-récepteur 23 est configuré pour permettre la communication bidirectionnelle dans l'espace hertzien entre la montre et l'appareil électronique. Cette communication peut être semi-duplex, lorsque la montre et l'appareil électronique peuvent à la fois recevoir et envoyer des données, la transmission ne pouvant se faire entre les parties communicantes que l'une après l'autre. Cette communication peut aussi être full duplex, lorsque la montre 1 et l'appareil électronique peuvent envoyer et recevoir des messages simultanément.

Un tel module émetteur-récepteur 23 implémente des technologies de communication sans fil telles que le Bluetooth, le Wi-Fi, le Li-Fi (contraction de Light Fidelity), le WiMAX, la technologie de communication relative à une norme de réseau de téléphonie mobile, la technologie de communication relative à une norme de réseau satellitaire. En outre, ce module émetteur-récepteur 23 est apte à mettre en oeuvre une combinaison d'au moins deux de ces technologies précitées.

Dans ce dispositif de communication 3, l'unité d'alimentation électrique autonome 21 comporte un accumulateur d'énergie électrique 6 et un module photovoltaïque 5 comprenant au moins une cellule photovoltaïque encore appelée cellule solaire. Ce module photovoltaïque 5 est relié à l'accumulateur d'énergie électrique 6 via des éléments de connexions référencés 17b et 18 sur les figures 3 et 5. Ce module photovoltaïque 5 peut comprendre une ou des cellules élémentaires du type à hétérojonction ou multijonction, connectées en parallèle ou en série. Chaque cellule photovoltaïque de ce module 5, peut être réalisée, de manière connue de l'homme du métier, à partir de matériaux semiconducteur à base de cuivre, d'indium, de gallium et de sélénium, à base de tellurure de cadmium, à base d'arséniure de gallium monocristallin ou à base de silicium monocristallin ou polycristallin, ou à pérovskites. Il y a lieu de noter que ces exemples sont non limitatifs et que l'homme du métier saura trouver le type de cellule photovoltaïque adapté à l'invention.

Dans ce dispositif de communication 3, l'unité de contrôle 7 aussi appelée microcontrôleur, comporte un circuit électronique 8 comprenant des ressources matérielles en particulier au moins un processeur coopérant avec des éléments de mémoire ainsi que des bus d'adresses, de données et de contrôle. Cette unité de contrôle 7 est connectée à ladite au moins une source lumineuse 4, au module émetteur-récepteur 23 et à l'unité d'alimentation électrique autonome 21. Une telle unité de contrôle 7 comprend dans ses éléments de mémoire 4 un algorithme de gestion des données échangées entre le montre 1 et l'appareil électronique.

Par ailleurs lorsque le dispositif de communication 3 comprend plusieurs sources lumineuses 4, le fonctionnement de ces dernières peut alors être géré/contrôlé par l'unité de contrôle 7 de manière simultanée et/ou en séquence. De plus chaque source lumineuse 4 est gérée/contrôlée par cette unité de contrôle 7 de manière distincte. Dans ce contexte, la gestion du fonctionnement de chaque source lumineuse 4 peut consister de manière non limitative et non exhaustive en la réalisation des opérations suivantes : un allumage ou une extinction séquentiel (le), un allumage ou une extinction simultané (e) de deux ou plusieurs sources lumineuses 4, un clignotement d'une ou de plusieurs sources lumineuses 4, une définition d'une fréquence de clignotement pour chaque source lumineuse 4, une durée de clignotement pour chaque source lumineuse 4, une durée d'allumage ou d'extinction pour chaque source lumineuse 4, etc.

Une telle unité de contrôle 7 peut aussi comprendre dans ses éléments de mémoire un algorithme de gestion de l'accumulateur d'énergie électrique 6 en particulier la gestion de son rechargement par le module photovoltaïque 5 et la gestion de la consommation électrique par ladite source lumineuse 4 et/ou du module émetteur/récepteur 23.

Ainsi que nous l'avons évoqué, le dispositif de communication autonome 3 est donc compris dans le cadran 2a, 2b. Dans cette configuration, les éléments constitutifs de ce dispositif de communication 3 à savoir la source lumineuse 4, l'accumulateur d'énergie électrique 6, le module photovoltaïque 5, le module émetteur-récepteur 23 et l'unité de contrôle 7, sont compris dans une ou plusieurs couches 10, 11, 12, 13, 14 formant ce cadran 2a, 2b.

En référence aux figures 2 à 5, ce cadran 2a, 2b est formé constitué par un empilement 9a, 9b d'une pluralité de couches minces/fines 10, 11, 12, 13, 14, ces couches 10, 11, 12, 13, 14 sont reliées entre elles par un élément de liaison tel qu'une substance adhésive de manière à les unifier afin obtenir un empilement 9a, 9b de couches minces monolithique formant ainsi un cadran monobloc 2a, 2b. Cet élément de liaison peut aussi être un clip ou encore une vis. De telles couches 10, 11, 12, 13, 14 sont superposées dans l'empilement 9a, 9b de couches c'est-à-dire qu'elles sont agencées les unes au-dessus des autres dans ce cadran 2a, 2b selon un ordre défini. On notera qu'un tel empilement 9a, 9b de couches peut aussi être appelé un assemblage de couches. Dans cet empilement 9a, 9b, les couches sont sensiblement similaires en présentant des surfaces supérieures et inférieures sensiblement de mêmes aires/superficies participant ainsi à former la paroi périphérique du cadran 2a, 2b qui est dépourvue de relief.

On notera que ces couches minces ou fines sont des couches qui présentent chacune *une épaisseur micrométrique.* En effet, chaque couche peut présenter une épaisseur comprise entre 1 et 100 µm, de préférence 2 µm, ou de préférence 3 µm. S'agissant de l'épaisseur du cadran 2a, 2b, il peut être compris entre 8 et 400 µm, de préférence 6 µm ou de préférence 12 µm ou de préférence 100 µm ou de préférence 200 µm ou de préférence 300 µm.

Ainsi un tel cadran monobloc 2a, 2b, présente en outre l'avantage de pouvoir être monté de manière amovible dans le boitier 19 de la montre 1 en plus de faciliter son intégration dans ce boitier 19.

Dans une première variante de cet empilement 9a de couches illustré sur la figure 3, ce dernier est constitué de quatre couches minces/fines 10, 11, 12, 13 successives suivantes :
- une première couche 10 formant/constituant la face visible 20a du cadran 2a incluant le module émetteur-récepteur 23 et/ou ladite au moins une source lumineuse 4 ;
- une deuxième couche 11 incluant le module photovoltaïque 5 ;
- une troisième couche 12 incluant un accumulateur d'énergie électrique 6 aussi appelé batterie rechargeable, et
- une quatrième couche 13 formant la face cachée 20b du cadran 2a incluant le module émetteur-récepteur 23 et/ou l'unité de contrôle 7.

La première couche 10 de cet empilement 9a, est de préférence rigide ou semi-rigide en comparaison avec les deuxième, troisième et quatrième couches minces/fines 11, 12, 13 qui sont de préférences souples ou flexibles. On comprend ici qu'une telle première couche 10 participe à rigidifier de manière structurelle l'empilement 9a de couches minces et donc le cadran 2a.

Dans cet empilement 9a, les première, deuxième, troisième et quatrième couches 10, 11, 12, 13, comprennent chacune une surface supérieure et une surface inférieure.

S'agissant de la première couche 10, elle est formée par un substrat transparent ou translucide ou au moins partiellement transparent ou au moins partiellement translucide qui est rigide ou semi-rigide. Un tel substrat est réalisé en une matière présentant une transmittance aux rayonnements solaires en particulier aux rayonnements ultraviolets aussi appelée UVT (pour « Ultra-Violet Transmission ») qui est comprise entre 65 et 95 pourcent. Cette transmittance est de préférence de 85 pourcent. Une telle matière peut être transparente ou translucide. Cette matière peut être de manière non limitative et non exhaustive un polymère, du verre ou encore de la céramique.

Dans ce contexte, on comprend que ce substrat est configuré pour que :
- la lumière produite par ladite au moins une source lumineuse puisse s'échapper vers l'extérieur du cadran 2a, 2b et donc de la montre 1, et
- la lumière provenant de l'environnement de la montre 1 puisse pénétrer dans le cadran 2a, 2b en direction du module photovoltaïque 5 du dispositif de communication 3, cette lumière comprenant des rayonnements solaires lorsqu'elle est d'origine naturelle.

Autrement dit, ce substrat transparent ou translucide est configuré pour être traversé par cette lumière susceptible d'alimenter le module photovoltaïque 5 afin que ce dernier puisse convertir l'énergie solaire provenant de ce rayonnement en énergie électrique.

Cette première couche 10 comprend aussi au moins une source lumineuse 4 qui est agencée dans le corps du substrat. Un tel agencement de la source lumineuse 4 dans ce substrat est configuré pour assurer un éclairage de tout ou partie de la face visible 20a du cadran 2a. Par exemple, un éclairage d'une représentation graphique relative à un paramètre de fonctionnement du dispositif de communication 3, telle qu'un élément de repère (ou affichage) comme un chiffre, un index, un trait, un point ou un éclairage d'une ou de plusieurs aiguilles, ou encore un éclairage de tout ou partie de la surface de la face visible du cadran 2a. Dans une variante, cette source lumineuse 4 peut avoir une forme prédéterminée telle que la forme d'un chiffre, d'une lettre, d'un index, d'un trait, d'un point, d'un logo ou encore d'un texte.

Cet éclairage peut être un éclairage de type rétroéclairage ou semi-direct lorsque la source lumineuse 4 est agencée dans une cavité définie dans le substrat. Plus précisément, cette cavité pouvant être une ouverture borgne réalisée dans la surface inférieure de ce substrat. Dans cette configuration, lorsque le fond de cette cavité comprend une représentation graphique relative à un paramètre de fonctionnement du dispositif de communication 3, le rayonnement lumineux, ou la lumière, produit par cette source lumineuse 4 peut s'échapper vers l'extérieur du cadran 2a via la face visible 20a de ce cadran 2a, autorisant ainsi la visualisation d'au moins une représentation graphique dans l'obscurité. En particulier, le rayonnement lumineux en s'échappant ainsi de la face visible 20a, vient dessiner le contour de cette représentation graphique. Dans ce contexte, cette représentation graphique comprise dans ou sur la surface supérieure ou encore sur la surface inférieure du substrat formant la première couche 10, est de préférence opaque ou non translucide ou non transparente.

Cet éclairage peut être un éclairage direct lorsque la source lumineuse 4 est agencée dans une cavité définie dans le substrat. Cette cavité peut être une ouverture borgne réalisée dans la surface inférieure de ce substrat et dont le fond est dépourvu de toute représentation graphique. Dans cette configuration, le rayonnement lumineux, ou la lumière, produit par cette source lumineuse 4 peut s'échapper par le fond de cette cavité vers l'extérieur du cadran 2a et donc par la face visible 20a de ce cadran 2a.

Cet éclairage peut aussi être un éclairage direct lorsque la source lumineuse 4 est agencée dans une ouverture traversante s'étendant dans l'épaisseur du substrat de la première couche 10, en débouchant en ses deux extrémités respectivement dans les surfaces supérieure et inférieure de ce substrat. Dans cette configuration, tout ou partie de la source lumineuse 4 peut faire saillie de la surface supérieure de ce substrat et donc de la première couche 10 ou de la face visible 20a du cadran 2a pour former une représentation graphique relative notamment à un paramètre de fonctionnement du dispositif de communication 3 telle qu'un index, un chiffre, un point, un trait, etc.

Un tel éclairage peut également être un éclairage déporté lorsque ladite au moins une source lumineuse 4 est couplée à au moins un guide d'onde. Ce guide d'onde encore appelé guide de lumière, permet d'amener la lumière depuis le point où elle injectée dans le guide jusque dans le substrat ou jusqu'à une zone du substrat (p. ex. : cavité, ouverture traversante) proche de la surface supérieure de ce substrat. Un tel guide de lumière peut être une fibre optique qui permet de contourner les éventuels obstacles qui peuvent se dresser dans le substrat par exemple entre l'élément électroluminescent et la zone du substrat proche de la surface supérieure de ce substrat, par laquelle la lumière va s'échapper. Dans cette variante de réalisation, c'est donc la lumière qui est amenée, via le guide d'onde, depuis l'élément électroluminescent jusqu'à cette zone du substrat à éclairer.

Dans une telle configuration, une première extrémité du guide d'onde est couplée avec la source lumineuse 4 et une deuxième extrémité de ce guide peut être agencée dans :
- une cavité pouvant être une ouverture borgne réalisée dans la surface inférieure du substrat de cette première couche 10, ou
- une ouverture traversante s'étendant dans l'épaisseur du substrat de la première couche 10 en débouchant en ses deux extrémités respectivement dans les surfaces supérieure et inférieure de ce substrat et donc de la première couche 10. Ainsi cette deuxième extrémité peut faire saillie de la surface supérieure du substrat ou de cette première couche 10 ou de la face visible 20a du cadran 2a afin par exemple de former une représentation graphique relative notamment à un paramètre de fonctionnement du dispositif de communication 3, comme par exemple un élément de repère tel qu'un index, un chiffre, un point, un trait, etc.

Dans ce contexte, l'éclairage indirect peut être réalisé par une seule source lumineuse 4 comprise sur la surface inférieure du substrat de cette première couche 10 en étant couplée à plusieurs guides d'onde dont les deuxièmes extrémités sont agencées dans :
- des cavités émettant chacune un rayonnement lumineux, provenant de cette source lumineuse 4, ce rayonnement s'échappant vers l'extérieur du cadran 2a via la face visible 20a en autorisant ainsi la visualisation d'au moins une représentation graphique dans l'obscurité. Dans ce contexte, cette représentation graphique comprise dans ou sur la face visible 20a du cadran 2a, ou la surface supérieure du substrat, est de préférence opaque, et/ou
- des ouvertures traversantes en faisant saillie ou pas de la surface supérieure de ce substrat afin de former des éléments de repères tels qu'un index, trait ou encore un point, et émettant chacune un rayonnement lumineux, provenant de cette source lumineuse 4.

Dans cette première couche 10, la source lumineuse 4 ou le module émetteur-récepteur 23 est appliquée/fixée sur la surface inférieure du substrat de cette première couche 10, dans une cavité ou sur une paroi interne d'une ouverture traversante évoquée précédemment et ce, par impression ou évaporation.

Dans cette première couche 10, le module émetteur-récepteur 23 est disposé dans/sur ce substrat afin de pouvoir capter les ondes radioélectriques. Ce module émetteur-récepteur 23 peut être agencé sur ou sous la surface supérieure de ce substrat formant la première couche 10. Lorsqu'il est agencé dans le substrat, ce module émetteur-récepteur 23 est positionné dans une cavité borgne ménagée dans cette surface supérieure. Dans une variante, il peut être agencé dans une cavité borgne réalisée dans la surface inférieure de ce substrat ayant pour fond cette surface supérieure. Dans cette configuration, les ondes radioélectriques se propageant dans le cadran 2a, 2b et dans la face visible 20a peuvent être captées par ledit module émetteur-récepteur 23. Ce substrat peut aussi comprendre une ouverture traversante reliant les surfaces supérieure et inférieure entre elles et dans lequel le module émetteur-récepteur 23 peut être agencé.

En outre, on notera que la surface inférieure de cette première couche 10 peut être autocollante afin de participer à son assemblage avec la deuxième couche 11.

Dans cet empilement 9a, la deuxième couche 11 comprend un substrat comportant le module photovoltaïque 5. Un tel substrat est de préférence flexible ou souple. Ce substrat de la deuxième couche 11, peut être un film sur lequel est disposé le module photovoltaïque 5. Enfin, ce substrat peut être réalisé en un matériau appartenant à la famille des polymères.

Dans cette deuxième couche 11, le module photovoltaïque 5 s'étend préférentiellement sur l'ensemble d'une zone dite active de la surface supérieure de ce substrat. Cette zone active est une portion de la surface supérieure du substrat qui est apte recevoir la lumière provenant de la surface inférieure de la première couche 10 du cadran 2a. Cette lumière qui a traversé tout ou partie de la première couche 10, provient de l'environnement extérieur du cadran 2a, et donc de la montre 1, ici principalement du rayonnement solaire lorsqu'elle est d'origine naturelle.

On notera que le module photovoltaïque 5 est appliqué sur la surface supérieure de ce substrat à partir de procédés d'impression par jet d'encre ou encore par sérigraphie ou à partir de procédés d'impression par évaporation thermique. On parlera d'ailleurs ici d'une deuxième couche 11 comprenant un module photovoltaïque 5 imprimé. En particulier, d'un module photovoltaïque 5 imprimé sur le substrat de la deuxième couche 11.

On remarquera qu'une fois le module photovoltaïque 5 a été appliqué sur le substrat, une couche d'une substance autocollante peut être déposée sur tout ou partie de la surface supérieure et/ou de la surface inférieure du substrat. Dans ces conditions, la deuxième couche 11 peut être une couche autocollante qui participe à faciliter son assemblage avec les autres couches en particulier avec la première couche 10 et/ou la troisième couche 12 de cet empilement 9a.

Dans l'empilement 9a, cette troisième couche 12 comprend aussi un substrat de préférence flexible ou souple, comportant l'accumulateur d'énergie électrique 6 du dispositif de communication autonome 3. Ce substrat de la troisième couche 12 peut être un film sur lequel est compris l'accumulateur 6. Un tel substrat peut être réalisé en un matériau appartenant à la famille des polymères.

Cet accumulateur 6 peut être une batterie au lithium ou encore une batterie à semi-conducteurs. Un tel accumulateur 6 est appliqué sur la surface supérieure de ce substrat à partir de procédés connus de l'état de la technique tels que :
- des procédés d'impression sur substrat polymère souple lorsqu'il s'agit par exemple d'une batterie au lithium, ou
- des procédés d'impression tridimensionnelle lorsqu'il s'agit par exemple d'une batterie à semi-conducteurs telle qu'une batterie lithium-métal à semi-conducteurs.

On parlera d'ailleurs ici d'une troisième couche 12 comprenant un accumulateur d'énergie électrique 6 imprimé. En particulier, d'un accumulateur d'énergie électrique 6 imprimé sur le substrat de la troisième couche 12.

Ainsi, de tels procédés permettent d'obtenir une troisième couche 12 comprenant cet accumulateur 6 qui est souple et ultrafine.

En outre, on remarquera qu'une fois l'accumulateur 6 appliqué sur le substrat, une couche d'une substance autocollante peut être déposée sur tout ou partie de la surface supérieure et/ou de la surface inférieure de ce substrat. Dans ces conditions, la troisième couche 12 peut être une couche autocollante qui participe à faciliter son assemblage avec les autres couches en particulier avec la deuxième couche 11 et/ou la quatrième couche 13 de cet empilement 9a.

On notera que cet accumulateur 6 sert à stocker l'énergie électrique produite par le module photovoltaïque 5 et à la restituer sur demande pour alimenter le dispositif de communication 3, ladite au moins une source lumineuse 4 et le module émetteur-récepteur 23.

Dans cet empilement 9a, cette quatrième et dernière couche 13 forme la face cachée du cadran 2a. Une telle quatrième couche 13 est formée par un substrat de préférence flexible ou souple, comportant l'unité de contrôle 7. Un tel substrat de la quatrième couche 13, peut être par exemple un PCB flexible sur lequel est agencée cette unité de contrôle 7 en particulier sur la surface supérieure de ce PCB et donc du substrat. Dans ce contexte, l'édification de l'unité de contrôle 7, et du module émetteur-récepteur le cas échéant, sur cette surface supérieure du substrat peut être réalisée à partir de procédés d'impression tridimensionnelle ou encore des procédés d'impression sur polymère.

Dans cette dernière et quatrième couche 13 de, le module émetteur-récepteur 23 est disposé dans/sur ce substrat afin de pouvoir capter les ondes radioélectriques. Ce module émetteur-récepteur 23 peut être agencé sur ou sous la surface inférieure de ce substrat formant cette quatrième couche 13. Lorsqu'il est agencé dans le substrat, ce module émetteur-récepteur 23 est positionné dans une cavité borgne ménagée dans cette surface inférieure. Dans une variante, il peut être agencé dans une cavité borgne réalisée dans la surface supérieure de ce substrat ayant pour fond cette surface inférieure. Dans cette configuration, les ondes radioélectriques se propageant dans le cadran 2a, 2b et dans la face cachée 20b peuvent être captées par ledit module émetteur-récepteur 23. Ce substrat peut aussi comprendre une ouverture traversante reliant les surfaces supérieure et inférieure entre elles et dans lequel le module émetteur-récepteur 23 peut être agencé.

Dans la deuxième variante, l'empilement 9b formant le cadran 2b, comprend trois couches minces/fines 10, 11, 14, reliées entre elles. On remarquera que cette deuxième variante se différencie de la première variante en ce qu'elle comprend donc trois couches 10, 11, 14 au lieu de quatre couches 10, 11, 12, 13, comme dans la première variante. Dans cette deuxième variante, l'accumulateur d'énergie électrique 6 du dispositif de communication 3 est maintenant compris dans la troisième et dernière couche 14 de cet empilement 9b avec l'unité de contrôle 7.

Une telle troisième et dernière couche 14 de cet empilement 9b, formant la face cachée du cadran 2b, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Une telle édification de l'accumulateur 6 et de l'unité de contrôle 7 sur cette surface supérieure du substrat, peut être réalisée à partir de procédés d'impression tridimensionnelle ou encore des procédés d'impression sur polymère. On notera qu'un tel substrat peut être par exemple un PCB flexible.

Dans cette dernière et troisième couche 14 de cette deuxième variante, le module émetteur-récepteur 23 est disposé dans/sur ce substrat afin de pouvoir capter les ondes radioélectriques. Ce module émetteur-récepteur 23 peut être agencé sur ou sous la surface inférieure de ce substrat formant la troisième couche 14. Lorsqu'il est agencé dans le substrat, ce module émetteur-récepteur 23 est positionné dans une cavité borgne ménagée dans cette surface inférieure. Dans une variante, il peut être agencé dans une cavité borgne réalisée dans la surface supérieure de ce substrat ayant pour fond cette surface inférieure. Dans cette configuration, les ondes radioélectriques se propageant dans le cadran 2a, 2b et dans la face cachée 20b peuvent être captées par le module émetteur-récepteur 23. Ce substrat peut aussi comprendre une ouverture traversante reliant les surfaces supérieure et inférieure entre elles et dans lequel le module émetteur-récepteur 23 peut être agencé.

En résumé dans cette deuxième variante, l'empilement 9b comprend alors :
- une première couche 10 formant la face visible 20a du cadran 2b incluant le module émetteur-récepteur 23 et/ou ladite au moins une source lumineuse 4 ;
- une deuxième couche 11 incluant le module photovoltaïque 5, et
- la troisième couche 14 formant la face cachée 20b du cadran 2b incluant le module émetteur-récepteur 23 et/ou l'accumulateur 6 et l'unité de contrôle 7.

On notera que dans cette deuxième variante, les première et deuxième couches 10, 11 sont similaires à celles de la première variante de l'empilement 9a.

Par ailleurs, en référence aux figures 3 et 5, le circuit électronique 8 de l'unité de contrôle 7 comprend des premiers éléments de connexion 15a qui sont reliés à des éléments de connexion 16 :
- de ladite au moins une source lumineuse 4 pour la gestion du fonctionnement de cette source lumineuse 4 pour l'affichage des différents paramètres de fonctionnement du dispositif de communication 3, et
- du module émetteur-récepteur 23 pour participer à la gestion des échanges de données entre la montre et l'appareil électronique.

Ce circuit électronique 8 comprend aussi des deuxièmes éléments de connexion 15b reliés à des premiers éléments de connexion 17a de l'accumulateur 6.

Dans une troisième variante non représentée, l'empilement de couches minces/fines formant le cadran comprend deux couches reliées entre elles. On remarquera que cette troisième variante se différencie de la deuxième variante en ce qu'elle comprend donc deux couches au lieu de trois couches 10, 11, 14, comme dans cette deuxième variante. Dans cette troisième variante, le module photovoltaïque 5 du dispositif de communication autonome 3 est maintenant compris dans la première couche et en particulier sur la surface inférieure du substrat formant cette première couche. Ce module photovoltaïque 5 peut être appliqué sur cette surface inférieure du substrat de cette première couche à partir de procédés d'impression par jet d'encre ou encore par sérigraphie ou à partir de procédés d'impression par évaporation thermique. On notera donc que cette première couche est alors similaire aux premières couches 11 des première et deuxième variantes, à l'exception du fait que dans cette troisième variante, la première couche comprend en plus le module photovoltaïque.

Par ailleurs dans la troisième variante, et de manière similaire à la deuxième variante, l'accumulateur d'énergie électrique 6 du dispositif de communication autonome 3 est compris dans la deuxième et dernière couche de cet empilement avec l'unité de contrôle 7. Une telle deuxième couche formant la face cachée du cadran, est constituée d'un substrat de préférence flexible ou souple, sur lequel sont édifiés, de préférence sur la surface supérieure de ce substrat, l'accumulateur 6 et le circuit électronique 8 constituant l'unité de contrôle 7. Cette édification de l'accumulateur 6 et de l'unité de contrôle 7 sur la surface supérieure du substrat, peut être réalisée à partir de procédés d'impression tridimensionnelle ou encore des procédés d'impression sur polymère. On notera qu'un tel substrat peut être par exemple un PCB flexible.

Dans les dernières couches 13, 14 des différentes variantes, le module émetteur-récepteur 23 est appliquée/fixée sur la surface inférieure ou supérieure du substrat de ces couches, dans une cavité ou sur une paroi interne d'une ouverture traversante évoquée précédemment, par impression ou évaporation.

En résumé dans cette troisième variante, l'empilement de couches comprend alors :
- une première couche formant la face visible 20a du cadran incluant le module émetteur-récepteur 23 et/ou ladite au moins une source lumineuse 4 et le module photovoltaïque 5, et
- une deuxième couche formant la face cachée 20b du cadran incluant le module émetteur-récepteur 23 et/ou l'accumulateur 6 et l'unité de contrôle 7.

En outre, on notera que les capteurs d'évènements du dispositif de communication 3, évoqués précédemment sont de préférence agencés dans la première couche 10 et/ou la dernière couche 13, 14 de l'empilement 9a, 9b de couches en étant reliés à l'unité de contrôle 7 de ce dispositif 3.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées.

## Revendications

1. Cadran (2a, 2b) de montre (1) comprenant un dispositif de communication sans fil autonome (3), un tel cadran (2a, 2b) comprend des faces visible et cachée (20a, 20b), ledit cadran (2a, 2b) étant formé par un empilement (9a, 9b) de couches minces (10, 11, 12, 13, 14) de matière s'étendant entre ces deux faces (20a, 20b), chacune desdites couches (10, 11, 12, 13, 14) comprenant un ou plusieurs des éléments fonctionnels compris dans ledit dispositif (3) :
- un module émetteur-récepteur (23) d'ondes radioélectriques ;
- au moins une source lumineuse (4) ;
- une unité d'alimentation électrique autonome (21), et
- une unité de contrôle (7) pour gérer le fonctionnement de ladite au moins une source lumineuse (4) et du module émetteur-récepteur (23).

2. Cadran (2a, 2b) selon la revendication précédente, dans lequel le module émetteur-récepteur (23) fonctionne selon une technologie Bluetooth, Wifi et/ou NFC.

3. Cadran (2a, 2b) selon l'une quelconque des revendications précédentes, dans lequel l'empilement (9a, 9b) de couches minces (10, 11, 12, 13) de matière comprend une première couche (10) pourvue de la face visible (20a) du cadran (2a, 2b) et la première couche (10) comprenant ledit au moins un module émetteur-récepteur (23) et ladite au moins une source lumineuse (4).

4. Cadran (2a, 2b) selon l'une quelconque des revendications précédentes, dans lequel ledit au moins un module émetteur-récepteur (23) est agencé dans une cavité ménagée dans la face cachée de ce cadran (2a, 2b).

5. Cadran (2a, 2b) selon l'une quelconque des revendications précédentes, dans lequel ladite première couche (10) est configurée pour être traversé en tout ou partie par un rayonnement lumineux notamment par un rayonnement solaire.

6. Cadran (2a, 2b) selon l'une quelconque des revendications précédentes, dans lequel ladite première couche (10) est en tout ou partie transparente ou translucide.

7. Cadran (2a, 2b) selon l'une quelconque des revendications précédentes, dans lequel l'empilement (9a, 9b) de couches minces (10, 11, 12, 13, 14) de matière comporte une deuxième couche (11) comprenant un module photovoltaïque (5) constituant l'unité d'alimentation électrique autonome (21).

8. Cadran (2a, 2b) selon l'une quelconque des revendications précédentes, dans lequel la deuxième couche (11) comprend un substrat sur lequel le module photovoltaïque (5) est imprimé.

9. Cadran (2a, 2b) selon l'une quelconque des revendications 7 et 8, dans lequel ledit module photovoltaïque (5) est disposé sur une zone active de ladite deuxième couche (11), ladite zone étant configurée pour recevoir des rayonnements lumineux provenant de la première couche (10) de l'empilement (9a, 9b) de couches minces (10, 11, 12, 13, 14) de matière.

10. Cadran (2a) selon l'une quelconque des revendications précédentes, dans lequel l'empilement (9a) comporte une troisième couche (12) comprenant un accumulateur d'énergie électrique (6) constituant l'unité d'alimentation électrique (21) autonome.

11. Cadran (2a) selon la revendication précédente, dans lequel la troisième couche (12) comprend un substrat sur lequel l'accumulateur d'énergie électrique (6) est imprimé.

12. Cadran (2a) selon l'une quelconque des revendications précédentes, dans lequel l'empilement (9a) comporte une quatrième couche (13) formant une face cachée (20b) du cadran (2a) comprenant l'unité de contrôle (7).

13. Cadran (2b) selon l'une quelconque des revendications 1 à 9, dans lequel l'empilement (9b) comporte une troisième couche (14) comprenant une face cachée (20b) du cadran (2a) comportant l'unité de contrôle (7) et un accumulateur d'énergie électrique (6) constituant l'unité d'alimentation électrique (21) autonome.

14. Cadran (2a, 2b) selon l'une quelconque des revendications précédentes, dans lequel la première couche (10) est rigide relativement aux autres couches (11, 12, 13, 14) comprises dans l'empilement (9a, 9b) de couches minces (10, 11, 12, 13, 14) de matière qui sont souples.

15. Cadran (2a, 2b) selon l'une quelconque des revendications précédentes, dans lequel lesdites faces visible et cachée (20a, 20b) sont planes ou bombées.

16. Montre (1) comprenant un cadran (2a, 2b) selon l'une quelconque des revendications précédentes.

17. Montre (1) selon la revendication précédente, **caractérisée en ce qu'**elle comprend un mouvement horloger mécanique, électronique ou électromécanique.
